# EUROPEAN PATENT SPECIFICATION

(11) **EP 0 550 811 B1**
(45) Date of publication and mention of the grant of the patent: **15.01.1997**
(21) Application number: 92118882.7
(22) Date of filing: 04.11.1992
(51) Int. Cl.: B32B 31/00

(54) **Wet liminating apparatus**
Vorrichtung zum Nasslaminieren
Appareil pour la lamination humide

(30) Priority: 10.01.1992 JP 22013/92
(43) Date of publication of application: 14.07.1993
(73) Proprietor: SOMAR CORPORATION, Tokyo 104 (JP)
(72) Inventor: Taguchi, Hiroshi, Toshima-ku, Tokyo (JP); Sumi, Shigeo, Hasuda-shi, Saitama (JP)
(74) Representative: Boeters, Hans Dietrich, Dr.

(56) References cited:
- EP-A- 0 336 358
- EP-A- 0 373 005

## Description

### BACKGROUND OF THE INVENTION

The present invention relates to a film sticking apparatus for sticking a film to a film-sticking surface of a base plate with pressure sticking rollers, while an air bubble preventive liquid remains applied to the base plate surface.

A printed circuit board for an electronic machine, such as a computer, has wiring made of copper or the like in a prescribed pattern on one or both sides of an electrically insulated base plate. A process for manufacturing the printed circuit board uses a stratified film, that consists of a photosensitive resin layer, which is a photoresist layer, and a light-transmissible resin film, which is a protective film for protecting the layer. The stratified film is stuck, under heat and pressure, to an electroconductive layer, which is a thin copper film, provided on the electrically insulated base plate. This heat and pressure sticking operation is performed by a film sticking apparatus in a mass production manner. One film sticking apparatus is disclosed in the Japan Patent Applications (OPI) Nos. 208037/88 and 8344/91 filed by the present Applicant (the term "OPI" as used herein means an "unexamined published application").

EP-A-0 373 005 describes another such apparatus for wet laminating a photopolymerizable film onto circuit board panels or other substrates. The apparatus is easily and quickly convertible from dry laminating to wet laminating with the rollers therefor mounted in bearing blocks which are insertable in slots in brackets at each end and removable therefrom. The lower roller (23) thereof has a gear (118) the teeth (120) of which are meshable with the teeth (112) of an idler gear (114) for transmission of rotation power thereto.

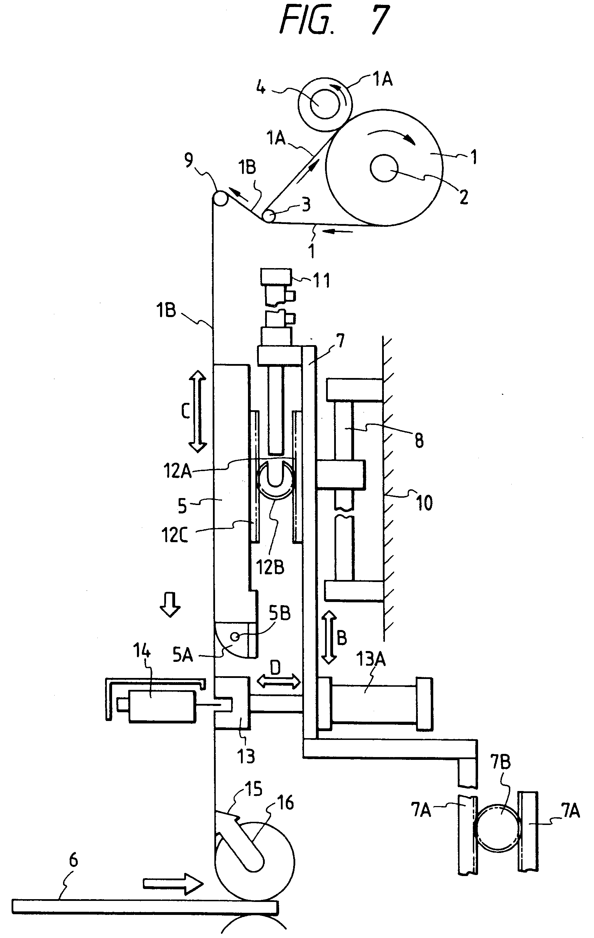

Fig. 7 shows a conventional film sticking apparatus. Since the apparatus is nearly symmetric above and below the conveyance passage (also referred to as the "conveyance path") for an electrically insulating base plate, Fig. 7 only illustrates the upper half of the apparatus and the vicinity surrounding the base plate conveyance passage. In this apparatus, a three-layer stratified film 1 is used which consists of three layers, a first light-transmissible resin film, a photosensitive resin layer and a second light-transmissible resin film. The film is continuously wound on a supply roller 2 prior to operation. The film 1 is unwound from the supply roller 2 in such a manner that a film separation roller 3 separates the first light-transmissible resin film 1A from the other two layers. The two-layer stratified film 1B consists of the second light-transmissible resin film and the photosensitive resin layer exposed on one side thereof, which is to be stuck to the base plate. The separated stratified film 1B is fed to the surface of a main vacuum suction plate 5 (which is a film feed member) along a tension roller 9.

An auxiliary vacuum suction plate 13 and a cutter 14 are provided along the film feed passage downstream of the main vacuum suction plate 5 with respect to the film feed direction. A vacuum suction bar 15 and a pressure sticking roller 16 are also provided along the feed passage downstream of the cutter 14. The pressure sticking roller 16 is generally made of a metal roll and a rubber sheet provided on the outer circumferential surface of the roll.

The main vacuum suction plate 5 is for tentatively sticking the stratified film 1B to an electroconductive layer on the base plate 6 while holding the film on the suction plate with a vacuum. The main vacuum suction plate 5 is supported by a support member 7 and is movable up and down. The support member 7 can be moved toward and away from the base plate 6 along directions B. The support member 7 is attached, via a guide member 8, to the body frame 10 of the apparatus so that the support member can be moved in the directions B while sliding on the guide member. A pair of support members 7 are provided, one above and one below the conveyance passage of the base plate 6. These support members are symmetrically movable up and down in conjunction with each other through the action of a rack and pinion mechanism, which is driven by a first driver not shown in Fig. 7. The mechanism includes racks 7A provided on the support members, and a pinion 7B engaged with the racks and supported by the body frame 10 of the apparatus.

The main vacuum suction plate 5 is supported by the support member 7 via a rack and pinion mechanism. The suction plate can be moved toward and away from the base plate 6 in directions C independently of the movement of the support member by a second driver 11, such as a pneumatic cylinder, through the action of the rack and pinion mechanism 12A-12C which is provided on the support member 7. The mechanism 12A-12C includes a first rack 12A secured to the support member 7, a pinion 12B engaged with the rack so as to be movable along the rack by the driver 11, and a second rack 12C engaged with the pinion so as to be movable parallel to the former rack. The main vacuum suction plate 5 has a tentative-sticking downstream end portion 5A in which a heater 5B is provided. To tentatively stick the stratified film 1B to the base plate 6 by the main vacuum suction plate 5, the tentative-sticking downstream end portion 5A of the suction plate is moved to the vicinity of the base plate or into contact therewith as the film remains attached to the end portion 5A. At that time, the end portion 5A is heated by the heater 5B to tentatively stick the leading edge of the film 1B to the leading edge of the base plate 6 under heat and pressure.

The auxiliary vacuum suction plate 13 sucks the leading edge of the stratified film 1B and holds the film edge against the end portion 5A of the main vacuum suction plate 5, which thereafter sucks the film and tentatively sticks the film to the base plate 6. The auxiliary vacuum suction plate 13 is moved toward and away from the film feed passage in directions D by a driver 13A such as a pneumatic cylinder, to pull the film against the end portion 5A.

The cutter 14 is opposed to the auxiliary vacuum suction plate 13 and is on the opposite side of the feed passage. The cutter cuts off the film to a length corresponding to the length of the base plate 6.

A pair of pressure sticking rollers 16 are also provided above and below the base plate conveyance passage. The upper and the lower stratified films 1B after being tentatively stuck to the base plate 6, are pinched thereon under prescribed pressure by the sticking rollers 16. The films are also heated by the rollers so that the films are completely stuck to the base plate under heat and pressure.

If an air bubble is generated in between the base plate 6 and the stratified film 1B during the sticking operation, a defective product is manufactured from the base plate through the use of the film. Thus, it is necessary to increase the tightness of the contact of the base plate 6 and the film 1B, especially in the case where the wiring pattern is complicated and the tightness is likely to decrease. In order to prevent the air bubble from being generated in between the base plate 6 and the film 1B, a wet roller 18 is provided in the film sticking apparatus to apply an air bubble preventive liquid, such as water, to the base plate before the film is stuck thereto under heat and pressure by the pressure sticking roller 16. A pair of wet rollers 18 are provided upstream of the upper and the lower pressure sticking rollers 16 with respect to the base plate conveyance direction. These wet rollers are provided in such a manner that it is not easy to attach and detach the wet rollers to the apparatus. The upper and lower sides of the base plate come into contact with the upper and the lower wet rollers, respectively, during the conveyance of the plate.

A wet roller was disclosed in the Japan Patent Application (OPI) No. 7344/91. The wet roller includes a liquid feed pipe, and a coating layer. The pipe has a cylindrical body made of a rust-resisting metal such as stainless steel, or a hard plastic, and a plurality of liquid feed holes provided in the body. The coating layer is made of a water-absorbing porous substance such as sponge, and is provided on the outer surface of the pipe. The air bubble preventive liquid is applied to the base plate by the wet roller by feeding the liquid from the liquid feed pipe to the coating layer through the ends of the pipe and the liquid feed holes. The coating layer is rotated in contact with the base plate so that the liquid clings thereto. However, since the coating layer of the wet roller is made of a porous substance such as sponge, the layer undergoes a plastic deformation, wear or the like over a prescribed period of use so that the liquid application performance of the layer deteriorates. Therefore, the wet roller needs to be replaced with another one in the prescribed period of use.

The conventional wet roller disclosed in the above-mentioned Application No. 7344/91 is provided in such a manner that it is not easily removed and replaced. Thus, it takes more time and trouble to replace the roller. This is a problem, which becomes serious when the film sticking apparatus is used in rapid continuous operation. Further, some base plates require the film to be stuck to the plate without wetting the plate with the air bubble preventive liquid. Therefore, the wetting roller must also be removed for these operations, and a similar problem occurs when detaching the wet roller to meet this requirement.

### SUMMARY OF THE INVENTION

The present invention was made in order to solve the above-mentioned problems. Accordingly, it is an object of the invention to provide a film sticking apparatus which includes a wetting roller capable of being easily replaced with another one so as to enhance the replacement efficiency, and to enhance removal when no air bubble preventive liquid is desired.

The present film sticking apparatus sticks the film to the film-sticking surface of the base plate by a pressure sticking roller. The present apparatus is characterized in that it assembles a single unit that includes a wet roller, support members and attaching members. The wet roller applies an air bubble preventive liquid, such as water, to the film-sticking surface of the base plate. The support members rotatably support the wet roller and the attaching members removably attach the wet roller with the support members to the apparatus to place the wet roller on a base plate conveyance passage. The unit is attached to the apparatus by the attaching members so that the unit is placed on the passage upstream of the pressure sticking roller with regard to the direction of the conveyance of the base plate to ensure that the liquid is applied to the base plate surface. This construction solves the problems noted above.

A pair of wet rollers are provided above and below the base plate conveyance passage in order to apply the air bubble preventive liquid to the upper and lower sides of the base plate. A drive roller may be provided on the base plate conveyance passage in order to convey the base plate. Transmission members are provided to transmit driving power of the driver roller to the wet roller. The attaching members may have notches in which engagement members provided at the base plate conveyance passage are engaged.

As for the film sticking apparatus provided in accordance with the present invention, the wet roller, the support members and the attaching members are assembled as one unit. When the wet roller installed in the apparatus is to be replaced with another one, the complete unit is replaced with another one. For that reason, the replacement of the wet roller is facilitated to enhance the replacement efficiency. It is also easy to detach the wet roller from the apparatus to allow the apparatus to perform sticking operations without the air bubble preventive liquid being applied thereto.

Further, a drive roller is provided on the base plate conveyance passage in order to convey the base plate. Transmission members are provided to transmit the power of the driver roller to the wet roller to rotate it. Thus, an exclusive driver does not need to be provided for the wet roller. This simplified the apparatus and enhances the air bubble preventive liquid applying performance of the apparatus in comparison with the case where a wet roller is rotated by a base plate being conveyed. However, a driver besides the driver roller may be provided for the wet roller.

If the attaching members have notches in which the engagement members provided at the base plate conveyance passage are engaged, the unit can be attached to and detached from the apparatus at the passage through easier and simpler manipulation.

### BRIEF DESCRIPTION OF THE DRAWINGS

The invention will be more clearly understood from the following description in conjunction with the accompanying drawings, wherein:
Fig. 1 is a schematic view of a film sticking apparatus which is an embodiment of the present invention;
Fig. 2 is a side view of the upper half of the apparatus and the vicinity surrounding the base plate conveyance passage;
Fig. 3 is a perspective view of a major part of the apparatus to illustrate the constitution and operation of wet rollers in detail;
Fig. 4 is a perspective view of a major part of the apparatus to illustrate the constitution and operation of guide rollers in detail;
Fig. 5 is a block diagram of the control system of the apparatus to illustrate the sending and reception of electric signals;
Fig. 6 is a flow chart of a procedure of the pressure sticking of a film by the apparatus to describe the operation thereof; and
Fig. 7 is a side view of the upper half of a conventional film sticking apparatus and the vicinity of a base plate conveyance passage to illustrate the constitution and operation of the apparatus.

### DETAILED DESCRIPTION OF THE PREFERRED EMBODIMENT

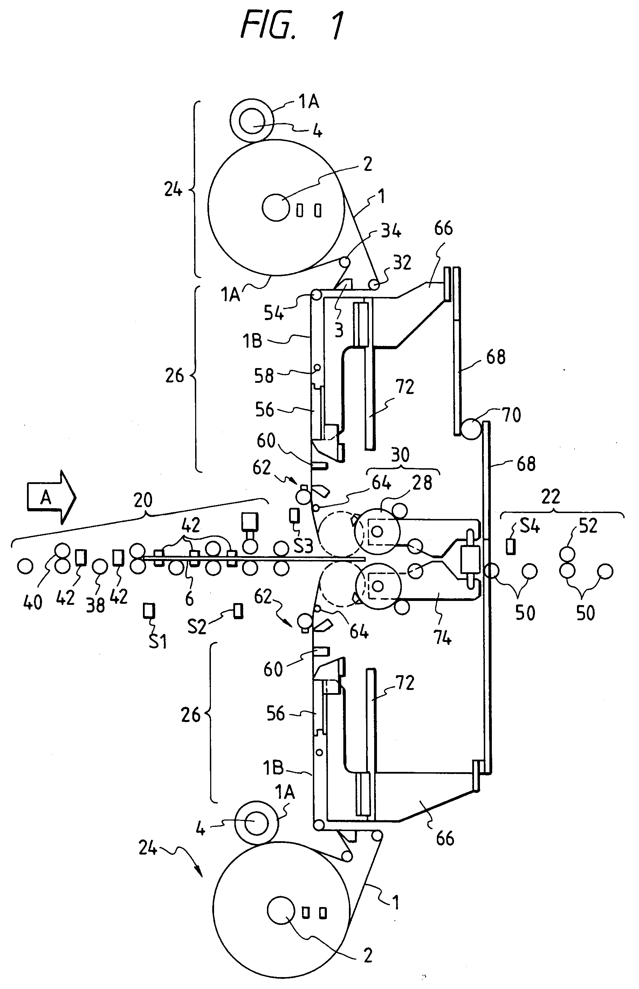

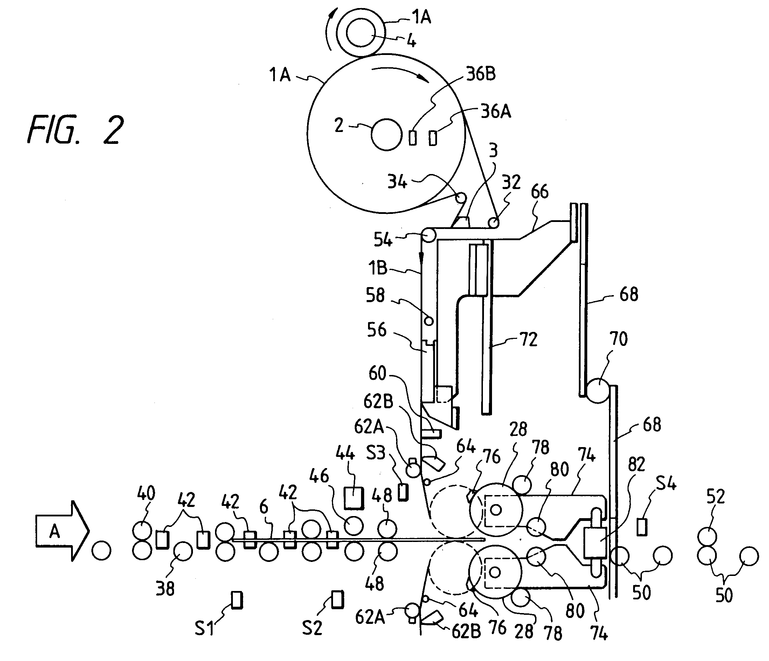

Fig. 1 is a schematic view of the present film sticking apparatus which operates so that upper and lower stratified films 1B, each having a length corresponding to that of an electrically insulating base plate 6, are stuck to the upper and lower sides of the plate, respectively. Fig. 2 is a side view of the upper half of the apparatus and the vicinity surrounding the base plate conveyance passage, which extends as the center line for the upper and lower halves of the apparatus. The apparatus generally includes a base plate convey-in section 20 for conveying in the base plate 6 to a tentative sticking position and a complete sticking position. A base plate convey-out section 22 conveys out the base plate with the stratified films 1B completely stuck thereto under heat and pressure. Stratified film storage sections 24 store three-layer stratified films 1, each of which consists of a light-transmissible resin film, a photosensitive resin layer and another light-transmissible resin film. The storage sections 24 feed the stratified films 1B to the base plate. The stratified films 1B consist of the light-transmissible resin film and the photosensitive resin layer exposed on one side thereof. Tentative sticking sections 26 tentatively stick the leading edges of the stratified films 1B to the upper and lower sides of the base plate. A pressure sticking section 30 operates to completely stick the stratified films 1B which is tentatively stuck at its leading edges, to the upper and lower sides of the base plate under heat and pressure by pressure sticking rollers 28.

In each of the stratified film storage sections 24, the three-layer stratified film 1 is continuously wound and stored prior to operation on a supply roller 2. The film 1 is unwound from the supply roller 2 to a film separation roller 3 along a guide roller 32 so that the separation roller separates the film into the light-transmissible resin film 1A, and the two-layer stratified film 1B. The two-layer film consists of the other light-transmissible resin film and the photosensitive resin layer, one side of which is exposed and is intended to be stuck to the base plate 6. The separated light-transmissible resin film 1A is wound onto a winding roller 4 along a guide roller 34 and the three-layer stratified film 1. A larger film winding diameter sensor 36A detects the diameter of the stratified film 1 wound on the supply roller 2 and determining whether it is larger than a prescribed value. A small film winding diameter sensor 36B detects that the film diameter is smaller than a prescribed value. Sensors 36A and 36B are provided alongside the film that is wound on the roller.

The base plate convey-in section 20 includes a plurality of drive rollers 38 that are provided at appropriate intervals along a base plate convey-in passage to apply driving forces to the base plate 6 to convey it. Motive power is applied to the driver rollers 38 from a driver such as a motor to rotate the rollers. Idle rollers 40 are provided opposite alternate or appropriate ones of the drive rollers 38 across the base plate conveyance passage so that the idle rollers and the driver rollers pinch the base plate 6 to surely apply the driving forces thereto. Sideward or lateral positioners 42 are provided in appropriate positions between the drive rollers 38 along the base plate conveyance passage to put the base plate 6 in a prescribed lateral position.

A base plate hold-down roller 46 is provided opposite the most downstream (with regard to the base plate conveyance direction) drive roller 38 across the base plate conveyance passage near the upstream end of the pressure sticking section 30. The hold-down roller 38 can be moved up and down by a base plate hold-down means 44 made of a pneumatic cylinder. When the base plate hold-down roller 46 is moved down by the base plate hold-down means 44, the base plate 6 is pinched between the hold-down roller and the corresponding drive roller 38. This prevents the base plate from vertically moving as the stratified films 1B are tentatively and completely stuck to the base plate.

Wet rollers 48 are provided downstream of the most downstream drive roller 38 to apply an air bubble generation preventive liquid such as water to the base plate 6. This liquid prevents an air bubble from being generated in between the base plate and each of the stratified films 1B as they are stuck thereto. The wet rollers 48 are joined to a unit base 90 so that they can be disposed together at the conveyance passage for the base plate 6 and removed together from the passage.

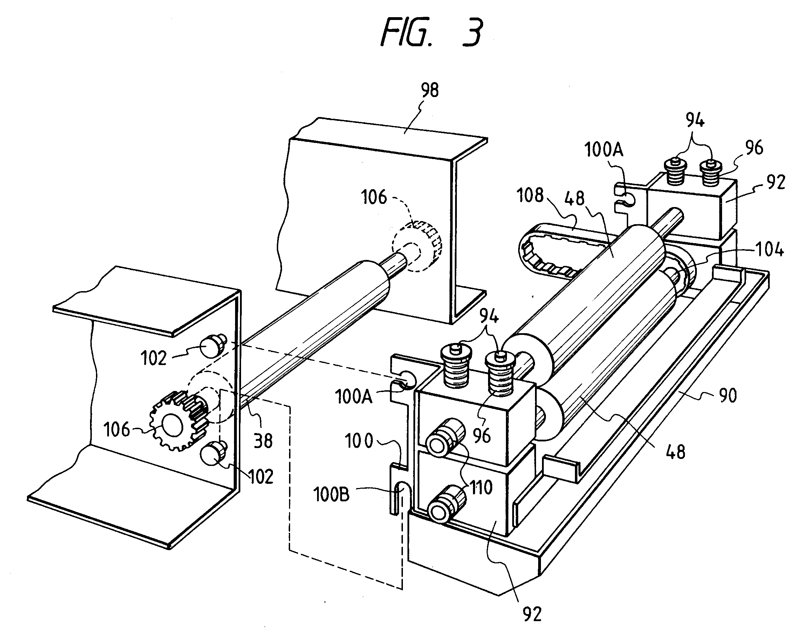

The wet rollers 48 and the unit base 90 are hereinafter described in detail with reference to Fig. 3. Sensors S1, S2 and S3 for the base plate 6 are provided near the base plate conveyance passage. The upstream sensor S1 is a positioning start location sensor which detects the leading edge of the base plate 6 brought into the convey-in section 20 and sends out a detection signal to put the sideward positioners 42 into action. The intermediate sensor S2 is a base plate trailing edge sensor provided downstream of the side positioning start location sensor S1 in order to detect the trailing edge of the base plate 6. The downstream sensor S3 is a base plate leading edge sensor provided near the upstream end of the pressure sticking section 30 in order to detect the leading edge of the base plate 6.

The base plate convey-out section 22 includes a plurality of drive rollers 50 that are provided so that the rollers are rotated by a motor to apply driving forces to the base plate 6 to convey it. Idle rollers 52 are provided opposite appropriate ones of the drive rollers 50 across the conveyance passage for the base plate 6 so that the base plate is pinched between the idle rollers and the driver rollers to surely apply the driving forces to the base plate. A base plate passing sensor S4 is provided near the downstream end of the pressure sticking section 30 in order to detect the passing of the base plate 6.

Each stratified film 1B is fed from the stratified film storage section 24 to the tentative sticking section 26 along a tension roller 54 which is for applying an appropriate tensile force to the film between the supply roller 2 and a main vacuum suction plate 56 (which is a film feed member). This tension prevents the film from wrinkling or the like while being fed to the main vacuum suction plate. A static electricity eliminator 58 is provided at the feed passage for the stratified film 1B between the tension roller 54 and the main vacuum suction plate 56 to eliminate static electricity from the film. A film holding member 60, a cutter 62 and a support roller 64 are provided at a stratified film feed passage between the main vacuum suction plate 56 and the pressure sticking section 30.

The main vacuum suction plate 56 sucks the leading edge of the stratified film 1B onto the plate as the film is fed from the supply roller 2. The plate 56 is moved toward the leading edge of the conveyed base plate 6 to tentatively stick the film to the upper or lower side of the leading edge of the base plate. The suction plate 56 is secured to a mounting member 66 so that they are moved together. The upper and the lower main vacuum suction plates 56 simultaneously suck the upper and lower films 1B, and are simultaneously moved toward the base plate 6 to tentatively stick the films thereto.

The film holding member 60 sucks the leading edge of the stratified film 1B by negative pressure, and is moved back along the direction A of the conveyance of the base plate 6. Thus, the film is sucked and wound at the leading edge thereof onto the tentatively-sticking downstream end portion 56A of the main vacuum suction plate 56.

The cutter 62 has a rotary cutting member 62A and a fixed cutting member 62B. The rotary cutting means has a cutting edge, which extends like a part of a spiral line on the outer circumferential surface of the cylindrical member, and the fixed cutting member 62B has a straight cutting edge. The stratified film 1B is fed across the fixed cutting member 62B and is cut off by the cutter 62 perpendicularly to the film feed direction as the rotary cutting member 62A is rotated to approach the fixed cutting member to cut off the film to a prescribed length corresponding to that of the base plate 6. In order to cut off the film 1B perpendicularly to the film feed direction, one end of each of the rotary and the fixed cutting members 62A and 62B is moved along the film feed direction during film feeding so that the component of the speed of the movement of the cutoff point of the cutter, in the film feed direction, equals the film speed.

The support roller 64 is provided on a film feed passage between the cutter 62 and the pressure sticking roller 28 and is located on the same plane as the film feed passage along the suction surface of the main vacuum suction plate 56. The support roller 64 is for guiding the stratified film 1B to smoothly send it to the pressure sticking roller 28 after the cutter 62 cuts the film so that the film does not wrinkle or the like.

The upper and the lower mounting members 66, to which the upper and lower main vacuum suction plates 56 are secured, are similarly provided as shown in Fig. 1. Racks 68 are provided on the mounting members 66 and are engaged with pinions 70 to simultaneously move the mounting members toward the base plate 6 together with the main vacuum suction plates 56 while sliding on guide rails 72. The pinions 70 are rotated in prescribed positions on the body frame of the apparatus by a servomotor through an electromagnetic clutch to simultaneously move the upper and the lower racks 68 and the upper and the lower main vacuum suction plates 56. A pair of pneumatic cylinders are coupled to the upper and the lower mounting members 66 along the directions of the widths of the main vacuum suction plates 56 to simultaneously move the mounting members away from each other. The servomotor is driven to move the main vacuum suction plates 56 toward the base plate 6 to set a prescribed distance between the base plate and each main vacuum suction plate. After that, the electromagnetic clutch is disengaged, and the pneumatic cylinders are driven to move the main vacuum suction plates 56 to tentatively stick the leading edges of the stratified films 1B to the leading edges of the base plate. Thereafter, the cylinders are driven back to move the main vacuum suction plates away from the base plate.

The pressure sticking section 30 includes pressure sticking rollers 28 for completely sticking the stratified films 1B to the upper and lower sides of the base plate 6 under heat and pressure. Pressure sticking roller support members 74 movably support the rollers which move back and forth and vacuum suction bars 76 turn around the rollers while sucking the films on the bars. Pressure roller wiping rollers 78 remove the air bubble generation preventive liquid from the pressure sticking rollers and base plate wiping rollers 80 remove the liquid from the upper and lower sides of the base plate after the complete sticking of the films thereto.

Two pneumatic cylinders 82 vertically swing the upper and the lower pressure sticking roller support members symmetrically to each other to vertically move the pressure sticking rollers to completely stick the films to the base plate. The base plate wiping rollers 80 are rotatably supported at the pressure sticking roller support members 74 downstream of the pressure sticking rollers 28 so that the air bubble generation preventive liquid clinging to the base plate 6 is removed therefrom by the base plate wiping rollers. The pneumatic cylinders 82 are coupled to the right and left pairs of the upper and lower pressure sticking roller support members 74 to move the pressure sticking rollers 28 up and down.

The wet rollers 48, the unit base and their surrounding vicinity are described below in detail with reference to Fig. 3. The upper and the lower wet rollers 48 are provided over and under the base plate conveyance passage and face each other across the passage. The wet rollers 48 are supported at both ends of the rollers with wet roller support member 92. The length of the unit base 90 extends along the width of the base plate 6, and is nearly equal to the width of each wet roller 48. The upper and the lower wet roller support members 92 are fastened to the unit base 90 at both ends thereof, and have pairs of holes vertically extending through the members.

Pins 94 fit in the holes and fasten to the unit base 90 at the lower ends of the pins so that the wet roller support members 92 are slidable along the pins. Washers are secured to the upper portions of the pins 94. Springs 96 are provided around the pins 94 between the washers and the upper support members 92, and urge the members 92 downward. The air bubble generation preventive liquid is applied to the upper and lower sides of the base plate 6 by the upper and the lower wet rollers 48 as the rollers are rotated in contact with the base plate under appropriate pressure to pinch the plate. The urging forces of the springs 96 for the wet roller support members 92 can be modulated to make the pressure appropriate.

The drive rollers 38 and idle rollers 42 of the base plate convey-in section 20 are supported by the support members 98 thereof, as shown in Fig. 3. Wet roller attaching members 100 are fastened to the unit base 90 so that it is removably attached to the support members 98 at their ends nearer the pressure sticking rollers 28. The attaching members 100 extend from the unit base 90 at both ends thereof near the upper and the lower wet roller support members 92, to the support members 98 of the base plate convey-in section 20. The attaching members 100 have upper and lower engagement portions 100A and 100B, in which engagement screws or pins 102 provided on the support members, are engaged to attach the unit base thereto. The upper engagement portions 100A are notches open toward the support members 98 at the time of the attaching of the base 90 thereto. The lower engagement portions 100B are notches open downward at that time. The upper and lower engagement portions 100A and 100B of the wet roller attaching members 100 are thus engaged with the engagement screws or pins 102 to fasten the unit base 90 to the support members 98. For that reason, it is very easy to attach and detach the unit base 90 to and from the support members 98 to replace the wet rollers 48 with others.

Wheels 104 for timing belts 108 are mounted on the lower wet roller 48 at one or both ends thereof near the wet roller support members 92. Other wheels 106 for the timing belts 108 are mounted on one or both end portions of the driver roller 38 located nearest the pressure sticking rollers 28 and extending through the support members 98 at the ends thereof. The timing belts 108 are wound on the wheels 104 and 106 when the unit base 90 and the wet rollers 48 are attached to the support members 98 by engaging the engagement screws or pins 102 (also referred to as protrusions) in the engagement portions 100A and 100B of the wet roller attaching members 100. When the driver rollers 38 of the base plate convey-in section 20 are thereafter put in action, the wet rollers 48 are rotated synchronously with the driver rollers through the action of the driver rollers, the wheels 104 and 106 and the timing belts 108. A driver besides the driver roller 38 may be provided to rotate the wet rollers 48.

Each of the wet rollers 48 includes a liquid feed pipe having a cylindrical body made of a rust-resisting metal such as stainless steel and aluminum processed not to rust, or a hard plastic. Each roller 48 also has a plurality of liquid feed holes extending through the body, and a coating layer made of a liquid-absorbing porous substance such as sponge on the outer surface of the pipe, similarly to the wet rollers disclosed in the Japan Patent Application (OPI) No. 7344/91. However, each wet roller 48 may be otherwise constituted.

Liquid feed nipples 110 are provided on the wet roller support members 92 opposite the wet rollers 48, and communicate with the liquid feed pipes thereof to feed the air bubble generation preventive liquid to the rollers through pipes. The liquid is applied to the upper and lower sides of the base plate 6 by the coating layers of the rollers as they are rotated in contact with the base plate being conveyed.

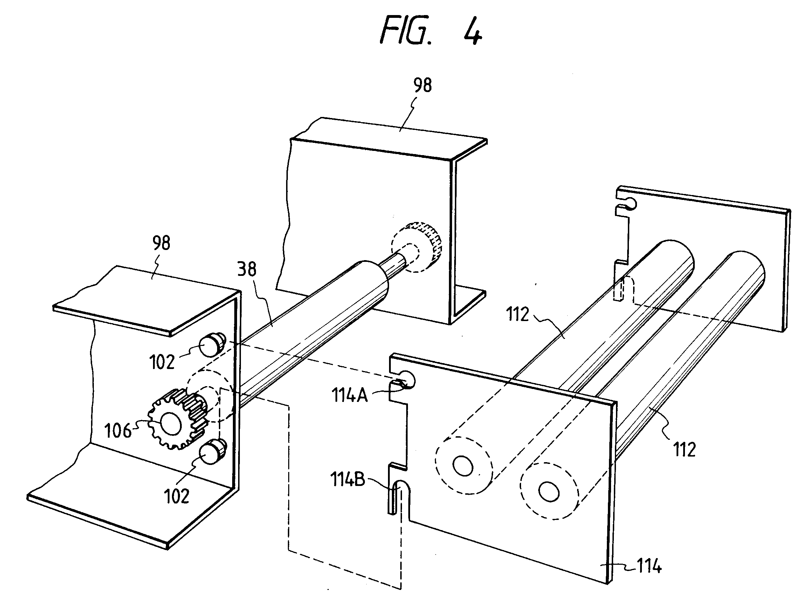

When the film sticking apparatus is to be used for sticking operations that do not use the air bubble generation preventive liquid, the assembly of the unit base 90, the wet rollers 48, the wet roller support members 92 and the wet roller attaching members 100 is detached from the support members 98 of the base plate convey-in section 20. Instead, guide rollers 112, shown in Fig. 4 are attached to the latter support members in place of the wetting rollers to guide the base plate on the tops of the guide rollers to the pressure sticking rollers 28 as the base plate is conveyed from the convey-in section to the pressure sticking section 30.

At that time, the guide rollers 112 are located at the ends of the support members 98, which face the pressure sticking rollers 28. The guide rollers 112 are supported at both ends of the shafts thereof by guide roller support members 114, whose engagement portions 114A and 114B are engaged with the engagement screws or pins 102 to attach the guide rollers to the support members 98. The engagement portions 114A and 114B are notches similar to notches 100A and 100B of the wet roller attaching members 100, and are locate at the support members 98 at the time of the engagement. The guide rollers 112 are rotatably supported by the guide roller support members 114 so that the motive power of the drive roller 38 is not transmitted to the guide rollers.

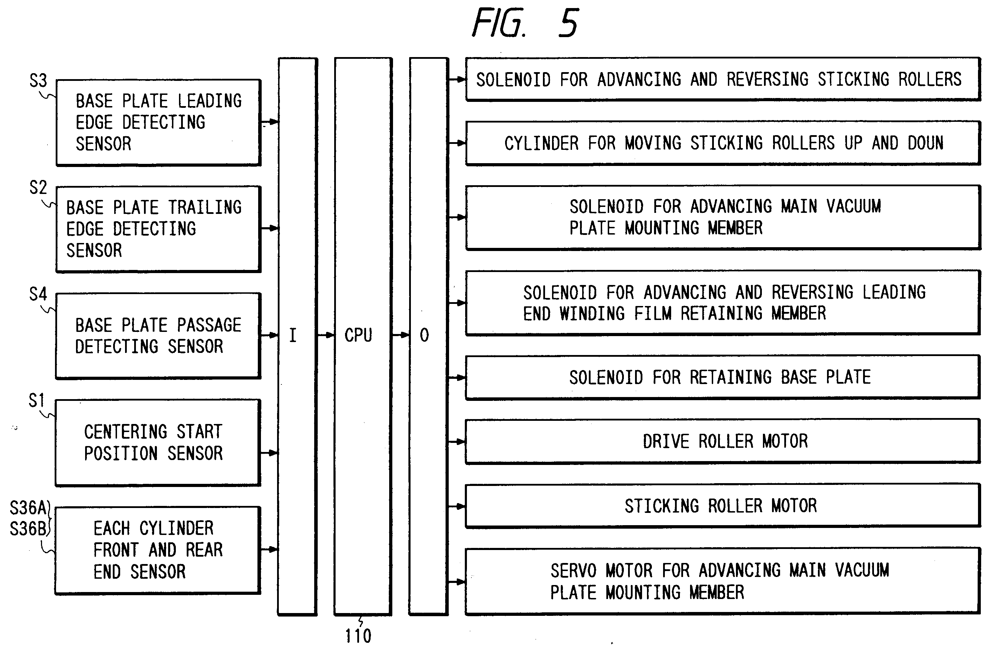

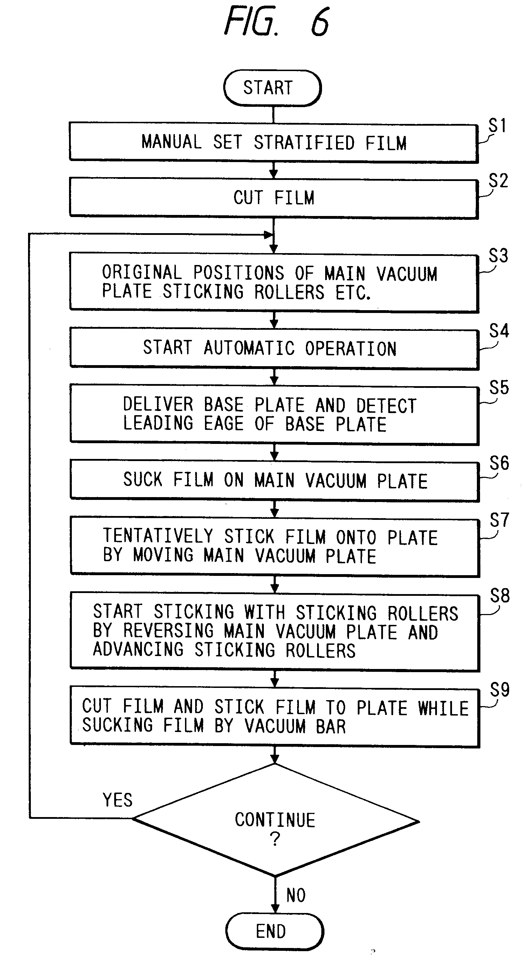

Fig. 5 is a block diagram of the control system of the film sticking apparatus that illustrates the sending and reception operations of the electric signals. In the control system, a central unit 110 sends out control signals for solenoids for the pneumatic cylinders and the motors in response to detection signals from the sensors S1, S2, S3, S4, S36A and S36B, and other sensors which are not shown in the drawings but are for detecting the front and rear ends of the piston rods of the cylinders. The central control unit 110 has counting and timing functions as well, and regulates the apparatus in a procedure shown in Fig. 6. For example, the control unit 110 is made of a programmable controller or a relay sequence control circuit.

Operating the film sticking apparatus is described in detail from now on. The apparatus is mainly operated by the procedure shown in Fig. 6. Since the upper and lower halves of the apparatus are operated symmetrically to each other, the operation of the upper half is mainly described hereinafter. First, the apparatus is manually put in a film sticking start preparation state in step 1. At that time, the supply roller 2 with the three-layer stratified film 1 sufficiently wound thereon is set in the apparatus. The film is unwound from the roller along the guide roller 32 and separated into the light-transmissible resin film 1A and the two-layer stratified film 1B by the film separation roller 3. The separated two-layer stratified film is moved forth along the main vacuum suction plate 56 and the cutter 62. The film is passed through the gap between the rotary and fixed cutting members 62A and 62B of the cutter. The passage can be defined between the members by manually separating the rotary cutting member from the fixed one.

The stratified film 1B is thereafter cut off by the cutter 62 in step 2. At that time, the rotary cutting member 62A is manually rotated for the cutoff. During this first cutting operation, the rotary and the fixed cutting members 62A and 62B are not inclined. The main vacuum suction plate 56, the pressure sticking roller 28 and so forth are put in their original positions in step 3. At that time, the upstream end of the main vacuum suction plate 56 is located slightly below the highest ascent position of the end. The film feed surfaces of the plate and the film holding member 60 are put on the same plane.

The apparatus is thereafter put in an automatic operating mode in step 4. As a result, the film holding member 60 sucks the stratified film 1B on the member and moves the film parallel to the base late conveyance direction. This parallel motion causes the film to be sucked onto the tentatively-sticking downstream end portion 56A of the main vacuum suction plate 56. The base plate 6 is introduced into the base plate convey-in section 20. After the base plate is detected by the positioning start location sensor S1, the base plate is put in the prescribed lateral position by the sideward positioners 42.

When the leading edge of the base plate 6 thus positioned laterally is detected by the base plate leading edge sensor S3 during the conveyance of the base plate in the conveyance passage, a detection signal is output. This sensor output causes a first counter in the central control unit 110 to start counting for a prescribed time. When the count reaches the prescribed time, the leading edge of the base plate 6 is stopped in the tentative sticking position. The detection signal also causes a second counter in the control unit 110 to start counting. When the second count has been performed for a prescribed time, the film holding member 60 is moved back along the base plate conveyance direction. This causes the stratified film 1B to be sucked and wound onto the tentatively-sticking downstream end portion 56A of the main vacuum suction plate 56 as mentioned above.

By the time that the main vacuum suction plate 56 is moved down to tentatively stick the stratified film 1B to the base plate 6, the base plate hold-down means 44 has already been driven to move down the base plate hold-down roller 46 to pinch the base plate between the roller and the driver roller 38. The air bubble generation preventive liquid is applied to the upper and lower sides of the base plate 6 by the wet rollers 48 as the base plate is conveyed forth. The main vacuum suction plate 56 is then moved down to tentatively stick the stratified film 1B at the leading edge thereof the base plate 6 in step 7.

During the second counting operation, a servomotor is driven to move the upper and lower main vacuum suction plates 56 simultaneously and at equal speeds toward the upper and lower rides of the base plate 6 through the action of the pinion 70 and the racks 68. The servomotor is stopped when each of the downstream ends of the main vacuum suction plates 56 is moved to a position located at the prescribed distance (2 cm, for example) from the base plate 6. After that, the pair of pneumatic cylinders provided at both ends of the upper and lower main vacuum suction plate 56 are driven. These cylinders move the plates so that the tentatively-sticking downstream end portions 56A thereof approach the upper and lower sides of the base plate 6 to tentatively stick the stratified films 1B to the upper and lower sides of the base plate under the pushing power of the cylinders. For that reason, the films 1B can be tentatively stuck to the upper and lower sides of the base plate 6 by mutually equal forces. At that time, the electromagnetic clutch is disengaged to keep the motive power of the servomotor from being transmitted to the pinion 70.

After that, the main vacuum suction plate 56 is moved away from the base plate 6, and the pressure sticking roller 28 is moved forth without interfering with the tentatively-sticking downstream end portion 56A of the suction plate, and starts completely sticking the tentatively-stuck stratified film 1B to the base plate under heat and pressure, in step 8. When the portion of the stratified film 1B, which is to become the trailing edge of the film when the portion is cut off by the cutter 62, has come to the place of the cutter along with the progress of the sticking of the film to the base plate 6 by the pressure sticking roller 28, the film is sucked on the main vacuum suction plate 56 and cut off by the cutter 62, in step 9. At the beginning of the cutoff, the cutter 62 is inclined so that the component of the speed of the cutting point movement that is in the film feed direction is equal to the film feeding speed to cut the film perpendicularly to the feed direction.

During and after the cutoff, the stratified film 1B is guided by the support roller 64 so that even if the diameter of the pressure sticking roller 28 is small, the film is fed forth without sliding on the fixed cutting member 62B of the cutter 62. During the complete sticking of the film 1B to the base plate 6 and after the cutoff, the vacuum suction bar 76 starts sucking the film 1B on the bar so that the film slides on the outer surface of the bar while being completely stuck to the base plate 6 under heat and pressure. When the trailing edge of the film 1B reaches the vicinity of the vacuum suction bar 76, the bar is turned around the pressure sticking roller 28 toward the base plate 6 so that the bar keeps sucking the film on the bar until immediately before the termination of the sticking of the film to the base plate. For that reason, an appropriate tensile force is applied to the film 1B to prevent it from wrinkling or the like. After the film 1B is cut off by the cutter 62, the main vacuum suction plate 56 and the film holding member 60 suck the following part of the film so that the part is held on the suction plate and the holding member.

It is then judged whether the film sticking operation of the apparatus should be continued or not. If it is judged that the film sticking operation should be continued, then steps 5, 6, 7, 8 and 9 are taken again. If it is not judged so, the operation is ceased.

The invention may be embodied as a film sticking apparatus different in type from the above-described one and including the same wet rollers as the above-mentioned ones 48.

According to the present invention, the replacement of wet rollers is facilitated to enhance replacement efficiency and to make it easier to prepare for sticking operations which do not use air bubble generation preventive liquid.

## Claims

1. A film sticking apparatus for sticking a film (1) to a base plate (6), comprising:
a conveyor section (20) for conveying a base plate to a sticking section (30),
means (32, 54, 56, 60, 64, 66) for feeding a film to said sticking section,
means (28), at said sticking section, for sticking said film to said base plate (6),
a wetting roller (48) for applying an air bubble preventive liquid to the base plate,
wetting roller support members (92) for rotatably supporting said wetting roller (48),
a wetting unit base (90), and
wetting roller attaching members (100) for removably attaching said wetting roller, said wetting roller support members, and said wetting unit base (90) to said conveyor section (20), wherein said wetting roller (48), wetting roller support members (92), wetting roller attaching members (100) and said wetting unit base (90) are removable from said conveyor section (20) as a single unit.

2. A film sticking apparatus according to claim 1, wherein said wetting roller attaching members, when attached to said conveyor, are arranged to position said wetting roller along a conveyance path of the base plate.

3. A film sticking apparatus according to claim 1, wherein the wetting roller includes a pair of wetting rollers, one of which is above and one of which is below a conveyance path of the base plate, said pair of wetting rollers applying the air bubble preventive liquid to upper and lower sides of the base plate.

4. A film sticking apparatus according to claims 1 or 2, further comprising:
a driver roller (38), connected to the conveyor and positioned along a conveyance path of the base plate, for conveying the base plate along said conveyance path; and
transmission members (104, 106, 108), connected between said driver roller and said wetting roller, for transmitting driving power from the driver roller to the wetting roller.

5. A film sticking apparatus according to any of claims 1-3, wherein the wetting roller attaching members (100) have engagement portions (100A, 100B) and said conveyor section (20) includes protrusions (102) provided above and below the base plate conveyance path, said engagement portions (100A, 100B) engaging said protrusions (102) to hold the wetting roller in position.

6. A film sticking apparatus according to claim 1, wherein said wetting roller supporting members (92) are at opposite ends of the wetting roller, said wetting roller support members being fastened to the wetting unit base (90) with pins (94), said wetting roller and wetting roller supporting members being slidable along said pins, said pins including springs (96) thereon to apply a downward force on the supporting members (92) to urge the wetting roller toward the base unit.

7. A film sticking apparatus according to claim 6, wherein the downward force of the springs is adjustable to change an amount of downward pressure exerted by the wetting roller onto the base plate as the base plate moves between the wetting roller and the base unit.

8. A film sticking apparatus according to claim 1, wherein said conveyor section (20) includes:
conveyance support members (98) for supporting drive (38) and idle (40) rollers, said drive and idle rollers pinching and conveying the base plate along the conveyance path, said wetting roller (48) having a wheel (104) and timing belt (108) attached to one end thereof, said timing belt being removably connected to one of said drive rollers to transfer a driving force from the drive roller to the wetting roller.

9. A film sticking apparatus according to claim 1, further comprising:
conveyance section supporting members (98), connected to the conveyor section (20), with upper and lower protrusions (102), said wetting roller attachment members (100) have upper and lower engagement portions to engage said upper and lower protrusions (102) to hold said wetting roller (48) at a desired position along said conveyance path of the base plate.

10. A film sticking apparatus according to claim 1, wherein said film sticking apparatus is operable when said wetting roller is attached to the conveyor to apply air bubble preventive liquid to the base plate and when said wetting roller is not attached to the conveyor such that the air bubble preventive liquid is not applied to the base plate.

## Patentansprüche

1. Eine Filmanklebevorrichtung zum Ankleben eines Films (1) auf eine Basisplatte (6), die aufweist:
einen Transportabschnitt (20) zum Transportieren einer Basisplatte zu einem Anklebeabschnitt (30),
Mittel (32, 54, 56, 60, 64, 66) zum Zuführen eines Filmes zu dem Anklebeabschnitt,
Mittel (28) an dem Anklebeabschnitt zum Ankleben des Films auf die Basisplatte (6),
eine Benetzungswalze (48) zum Zuführen einer luftblasenverhindernden Flüssigkeit zu der Basisplatte,
ein Benetzungswalzenhalteglied (92) zum drehbaren Halten der Benetzungswalze (48),
eine Benetzungseinheitsbasis (90), und
ein Benetzungswalzenbefestigungsglied (100) zum entfernbaren Befestigen der Benetzungswalze, des Benetzungswalzenhalteglieds und der Benetzungseinheitsbasis (90) an den Transportabschnitt (20), wobei die Benetzungswalze (48), die Benetzungswalzenhalteglieder (92), die Benetzungswalzenbefestigungsglieder (100) und die Benetzungseinheitsbasis (90) als eine zusammengehörige Einheit von dem Transportabschnitt (20) entfernbar sind.

2. Eine Filmanklebevorrichtung nach Anspruch 1, worin die Benetzungswalzenbefestigungsglieder, wenn sie an dem Transporter befestigt sind, so beschaffen sind, daß sie die Benetzungswalze entlang einem Transportweg der Basisplatte positionieren.

3. Eine Filmanklebevorrichtung nach Anspruch 1, worin die Benetzungswalze ein Paar Benetzungswalzen umfaßt, von denen sich eine oberhalb und eine unterhalb des Transportweges der Basisplatte befindet, wobei das Benetzungswalzenpaar die luftblasenverhindernde Flüssigkeit auf die oberen und unteren Seiten der Basisplatte aufbringt.

4. Eine Filmanklebevorrichtung nach den Ansprüchen 1 oder 2, die ferner aufweist:
eine Antriebswalze (38), die mit dem Transporter verbunden und entlang einem Transportweg der Basisplatte zum Transportieren der Basisplatte entlang des Transportwegs angeordnet ist; und
Übertragungsglieder (104, 106, 108), die zwischen der Antriebswalze und der Benetzungswalze zum Übertragen der Antriebskraft von der Antriebswalze auf die Benetzungswalze angeordnet sind.

5. Eine Filmanklebevorrichtung nach einem der Ansprüche 1 bis 3, worin das Benetzungswalzenbefestigungsglied (100) Eingriffsabschnitte (100A, 100B) aufweist und der Transporterabschnitt (20) Vorsprünge (102) aufweist, die oberhalb und unterhalb des Basisplattentransportwegs angeordnet sind, wobei die Eingriffsabschnitte (100A, 100B) mit den Vorsprüngen (102) ein Eingriff sind, um die Benetzungswalze in Position zu halten.

6. Eine Filmanklebevorrichtung nach Anspruch 1, worin die Benetzungswalzenhalteglieder (92) an entgegengesetzten Enden der Benetzungswalze angeordnet sind, wobei die Benetzungswalzenhalteglieder mit Stiften (94) an die Benetzungseinheitsbasis (90) befestigt sind, wobei die Benetzungswalze und die Benetzungswalzenhalteglieder entlang der Stifte gleitbar sind, wobei die Stifte mit Federn (96) versehen sind, um eine nach unten gerichtete Kraft auf die Halteglieder (92) auszuüben, damit die Benetzungswalze in Richtung der Basiseinheit gedrückt wird.

7. Eine Filmanklebevorrichtung nach Anspruch 6, worin die nach unten gerichtete Kraft der Federn verstellbar ist, um die Größe des von der Benetzungswalze auf die Basisplatte ausgeübten nach unten gerichteten Drucks zu ändern, während die Basisplatte sich zwischen der Benetzungswalze und der Basiseinheit bewegt.

8. Eine Filmanklebevorrichtung nach Anspruch 1, worin der Transportabschnitt (20) aufweist:
Transporthalteglieder (98) zum Halten der Antriebs- (38) und Mitläuferwalzen (40), wobei die Antriebs- und Mitläuferwalzen die Basisplatte entlang des Transportweges einklemmen und transportieren, wobei ein Rad (104) und ein Synchronriemen (108) an einem Ende der Benetzungswalze (48) befestigt ist, wobei der Synchronriemen entfernbar mit einem der Antriebswalzen verbunden ist, um eine Antriebskraft von der Antriebswalze auf die Benetzungswalze zu übertragen.

9. Eine Filmanklebevorrichtung nach Anspruch 1, die ferner aufweist:
ein mit dem Transportabschnitt (20) verbundenes Transportabschnitthalteglied (98) mit oberen und unteren Vorsprüngen (102), wobei die Benetzungswalzenbefestigungsglieder (100) obere und untere Eingriffsabschnitte zum Eingreifen in die oberen und unteren Vorsprünge (102) aufweisen, um die Benetzungswalze (48) an einer gewünschten Position entlang dem Transportweg der Basisplatte zu halten.

10. Eine Filmanklebevorrichtung nach Anspruch 1, worin die Filmanklebevorrichtung betriebsbereit ist, wenn die Benetzungswalze an dem Transporter befestigt ist, um eine luftblasenverhindernde Flüssigkeit auf die Basisplatte aufzubringen, und wenn die Benetzungswalze nicht an dem Transporter befestigt ist, so daß die luftblasenverhindernde Flüssigkeit nicht auf die Basisplatte aufgebracht wird.

## Revendications

1. Appareil de collage d'un film (1) sur une plaque de base (6) comprenant :
une section de transporteur (20) destinée à transporter une plaque de base à une section de collage (30),
un dispositif (32, 54, 56, 60, 64, 66) destiné à faire avancer un film vers la section de collage,
un dispositif (28) placé à la section de collage et destiné à coller le film à la plaque de base (6),
un rouleau (48) de mouillage et d'application d'un liquide destiné à empêcher la formation de bulles d'air à la plaque de base,
des organes (92) de support du rouleau de mouillage de manière que le rouleau de mouillage (48) soit supporté en pouvant tourner,
une base (90) d'unité de mouillage, et
des organes (100) de fixation du rouleau de mouillage destinés à fixer de façon amovible le rouleau de mouillage, les organes de support du rouleau de mouillage et la base (90) d'unité de mouillage à la section (20) de transporteur, le rouleau de mouillage (48), les organes (92) de support du rouleau de mouillage, les organes (100) de fixation de rouleau de mouillage et la base (90) d'unité de mouillage pouvant être retirés de la section (20) de transporteur sous forme d'un tout.

2. Appareil de collage de film selon la revendication 1, dans lequel les organes de fixation du rouleau de mouillage, lorsqu'il est fixé au transporteur, sont disposés afin qu'ils positionnent le rouleau de mouillage le long d'un trajet de transport de la plaque de base.

3. Appareil de collage de film selon la revendication 1, dans lequel le rouleau de mouillage comprend une paire de rouleaux de mouillage dont l'un se trouve au-dessus et l'autre au-dessous d'un trajet de transport de la plaque de base, la paire de rouleaux de mouillage appliquant le liquide destiné à empêcher la formation de bulles d'air aux faces supérieure et inférieure de la plaque de base.

4. Appareil de collage de film selon la revendication 1 ou 2, comprenant en outre :
un rouleau menant (38) raccordé au transporteur et placé le long d'un trajet de transport de la plaque de base afin qu'il transporte la plaque de base le long du trajet de transport, et
des organes de transmission (104, 106, 108) connectés entre le rouleau menant et le rouleau de mouillage et destinés à transmettre de l'énergie d'entraînement du rouleau menant au rouleau de mouillage.

5. Appareil de collage de film selon l'une quelconque des revendications 1 à 3, dans lequel les organes (100) de fixation du rouleau de mouillage ont des parties de coopération (100A, 100B) et la section (20) de transporteur comporte des saillies (102) placées au-dessus et au-dessous du trajet de transport de la plaque de base, les parties de coopération (100A, 100B) coopérant avec les saillies (102) afin que le rouleau de mouillage soit maintenu en position.

6. Appareil de collage de film selon la revendication 1, dans lequel les organes (92) de support de rouleau de mouillage sont placés aux extrémités opposées du rouleau de mouillage, les organes de support du rouleau de mouillage étant fixés à la base (90) de l'unité de mouillage par des broches (94), le rouleau de mouillage et les organes de support du rouleau de mouillage pouvant coulisser le long des broches, les broches ayant des ressorts (96) montés sur elles et destinés à appliquer une force descendante aux organes de support (92) afin que le rouleau de mouillage soit poussé vers l'unité de base.

7. Appareil de collage de film selon la revendication 6 , dans lequel la force descendante des ressorts est réglable afin que l'amplitude de la pression descendante exercée par le rouleau de mouillage sur la plaque de base change lorsque la plaque de base se déplace entre le rouleau de mouillage et l'unité de base.

8. Appareil de collage de film selon la revendication 1, dans lequel la section de transporteur (20) comprend :
des organes (98) de support de section de transport destinés à supporter des rouleaux menants (38) et fous (40), les rouleaux menants et fous pinçant et transportant la plaque de base le long du trajet de transport, le rouleau de mouillage (48) ayant une roue (104) et une courroie de synchronisation (108) fixée à une première extrémité, la courroie de synchronisation étant raccordée de façon temporaire à l'un des rouleaux menants de manière qu'elle transfère une force d'entraînement du rouleau menant au rouleau de mouillage.

9. Appareil de collage de film selon la revendication 1, comprenant en outre :
des organes (98) de support de section de transport, raccordés à la section de transporteur (20) avec des saillies supérieures et inférieures (102), les organes (100) de fixation du rouleau de mouillage ont des parties supérieures et inférieures de coopération destinées à coopérer avec les saillies supérieures et inférieures (102) afin que le rouleau de mouillage (48) soit maintenu en position voulue le long du trajet de transport de la plaque de base.

10. Appareil de collage de film selon la revendication 1, dans lequel l'appareil de collage de film est destiné à fonctionner lorsque le rouleau de mouillage est fixé au transporteur afin qu'il applique un liquide destiné à empêcher la formation de bulles d'air à la plaque de base et, lorsque le rouleau de mouillage n'est pas fixé au transporteur, il est tel que le liquide destiné à empêcher la formation de bulles d'air n'est pas appliqué à la plaque de base.
